# EUROPEAN PATENT APPLICATION

(11) **EP 2 063 537 A1**
(43) Date of publication of application: **27.05.2009**
(21) Application number: 08019961.5
(22) Date of filing: 14.11.2008
(51) Int. Cl.: H03M 7/30

(54) **Systems and methods for rounding a truncated audio signal**

(30) Priority: 21.11.2007 US 943691
(71) Applicant: Broadcom Corporation, Irvine CA 92617 (US)
(72) Inventor: Core, Mark, Irvine, CA 92603 (US); Xu, Fan, Irvine, CA 92617 (US); Srinivas, Hosavalli, Irvine, CA 92620 (US)
(74) Representative: Jehle, Volker Armin

(57) **Abstract**

Systems and methods for increasing audio SNR in a NICAM digital sound decoder are provided. One method according to the invention includes receiving a scale factor that indicates a number of bits of a Near Instantaneous Companded Audio Multiplex (NICAM) signal that have been truncated from the signal. The method also includes receiving the NICAM signal itself. The NICAM signal may include a predetermined number of zero bits in place of the predetermined number of truncated bits. The method may also require appending a bit pattern to the NICAM signal that approximates a rounding of the NICAM signal. The bit pattern preferably includes at least one non-zero bit. Another method according to the invention may include selecting a bit pattern from a collection of bit patterns. The collection of bit patterns may include at least non-zero bit. The alternative embodiment of the invention may also include appending the selected bit pattern to the NICAM signal in order to replace a predetermined number of truncated bits.

## Description

### FIELD OF TECHNOLOGY

This invention relates to techniques used in NICAM (Near Instantaneous Companded Audio Multiplex) digital sound decoders. More particularly this invention relates to increasing the audio SNR in a NICAM digital sound decoder.

### BACKGROUND OF THE INVENTION

The NICAM digital stereo audio standard, EN 300 163 v1.2.1 NICAM (6 March 1998), which is incorporated by reference herein in its entirety, specifies that sound signals are sampled at 32KHz and coded initially with a resolution of 14 bits per sample. For transmission from a TV station or other suitable signal provider, the number of bits per sample can be reduced to 10 using companding. Companding is implemented as follows.

First, the 14-bit samples from each audio channel are partitioned into separate blocks of 32 samples, each of the samples corresponding to a 1 millisecond (ms) segment of sound. Then the amplitude of the largest sample value in each block is found. It is this largest sample that determines the amount of companding, and hence the coding range applied to all the data from the audio channel within that particular block.

The amount of data compression obtained by the companding is determined as follows. For the largest sample only the ten most significant, non-redundant bits of the sample are transmitted. There are five companding coding ranges which are signaled to the receiver by means of a 3-bit scale factor code.

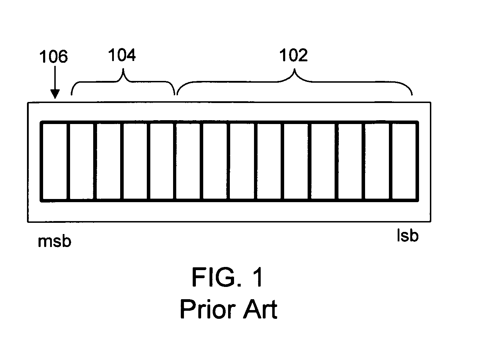

FIG. 1 shows a schematic diagram of a sample from a block in which the amplitude of the largest audio sample is up to one sixteenth of the maximum possible amplitude. In such a block of audio, the only processing performed is to reduce the number of bits in each sample in the block to ten bits (nine bits shown at 102 and the tenth shown at 106) by removing the four next-to-most significant bits 104 of the samples. For the purposes of this application, bit positions are illustrated as boxes, and a sample is a horizontal row of boxes. Such bits, except where described as truncated can typically be either a "0" or a "1". The most significant bit 106 (which is typically the sign bit), which is needed to identify the polarity of the sample, is always transmitted independent of the amplitude of the signal being coded.

For this range of sample values -- i.e., wherein the amplitude of the largest sample is up to one sixteenth of the maximum possible amplitude -- these four bits 104 are redundant and serve only as an extension of sign-bit 106 for each sample. Therefore, four bits 104 can be removed without any loss of the initial 14-bit coding accuracy.

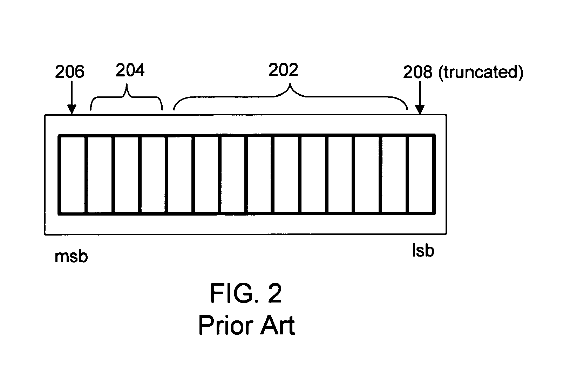

FIG. 2 shows a sample from a block where the largest sample is up to one eighth of the maximum 14-bit amplitude. Such a block is companded by truncating the least significant bit 208 of the sample and removing the three next-to-most significant bits 204 which are, as before, just an extension of the sign bit 206. Accordingly, samples in this range are transmitted with 13-bit coding accuracy. The 13 bits include bits 202, bits 204, and bit 206 -- all of which form part of the transmitted sample. In fact, the only bit that does not contribute to the accuracy of the sample is bit 208 which has been truncated.

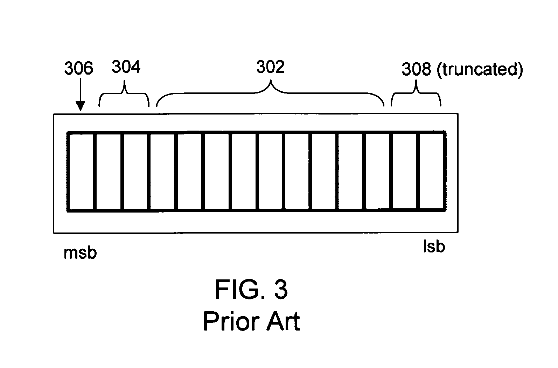

FIG. 3 shows a sample from a block where the largest sample is up to one quarter of the maximum 14-bit amplitude. Such a block is companded by truncating the two least significant bits 308 of the sample and removing the two next-to-most significant bits 304 which are, as before, just an extension of the sign bit 306. Accordingly, samples in this range are transmitted with 12-bit coding accuracy. The 12 bits include bits 302, bits 304, and bit 306 -- all of which form part of the transmitted sample. In this case, the only bits that do not contribute to the accuracy of the sample are bits 308, which have been truncated.

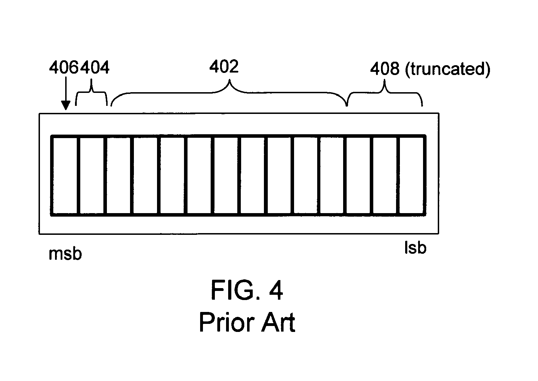

FIG. 4 shows a sample from a block where the largest sample is up to one half of the maximum 14-bit amplitude. Blocks such as that shown in FIG. 4 are companded by truncating the three least significant bits 408 of the sample and removing the one next-to-most significant bit 404 which is, as before, just an extension of the sign bit 406. Accordingly, samples in this range are transmitted with 11-bit coding accuracy. The 11 bits include (9) bits 402, (1) bit 404, and (1) bit 406 -- all of which form part of the transmitted sample. In this case, the only bits that do not contribute to the accuracy of the sample are (3) bits 408, which have been truncated.

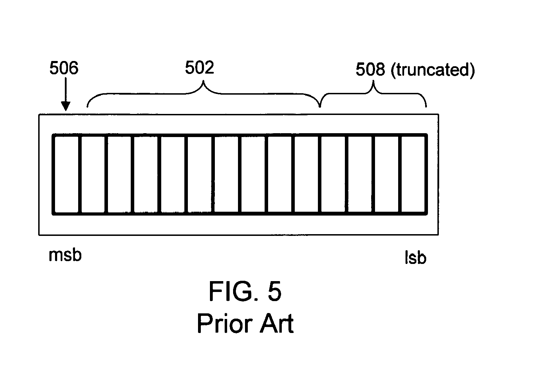

Blocks containing samples greater than one half of full amplitude are transmitted with only 10-bit accuracy, as shown in FIG. 5. Blocks such as that shown in FIG. 5 are companded by truncating the four least significant bits 508 of the sample. Accordingly, samples in this range are transmitted with 10-bit coding accuracy. The 10 bits include (9) bits 502, and (1) bit 506all of which form part of the transmitted sample. In this case, the bits that do not contribute to the accuracy of the sample are (4) bits 508, which have been truncated.

From the foregoing it is evident that blocks including higher amplitude samples are transmitted with lower accuracy.

The EN 300 163 v1.2.1 NICAM standard effectively specifies that anywhere from 0 to 4 least significant bits (lsb's) of the audio samples are truncated during companding in the encoder. This has been shown in FIGs. 1-5 and described above. When lsb's are truncated, this produces a biased quantization error for the companded signal in the sense that the mean value of the error is non-zero. Furthermore, the value of the biased error changes with the coding range to which each audio segment is assigned, and is therefore data dependent. In terms of quantization error, truncation typically produces about a 6dB lower SNR than rounding to the same number of bits.

It would be desirable to reduce the effect of the error attributable to truncation of bits as implemented in the companding process in the NICAM standard.

### SUMMARY OF THE INVENTION

A system and/or method for improving the SNR of a digital sound decoder, substantially as shown in and/or described in connection with at least one of the figures, as set forth more completely in the claims.

According to an aspect, a method comprises:
receiving a Near Instantaneous Companded Audio Multiplex (NICAM) signal, the NICAM signal that comprises a plurality of bits, a predetermined number of the plurality of bits having been truncated at the signal transmitter;
receiving a scale factor that indicates the predetermined number of truncated bits; and
appending a bit pattern to the NICAM signal, the bit pattern that replaces the predetermined number of truncated bits, the bit pattern comprising at least one non-zero bit.

Advantageously, the predetermined number of truncated bits is one of 1 bit, 2 bits, 3 bits, and 4 bits.

Advantageously, the bit pattern is one of 0111, 011, and 01.

Advantageously, the bit pattern is one of 1000, 100, 10, 1.

Advantageously, the predetermined number of truncated bits is one of 1 bit, 2 bits, 3 bits, and 4 bits.

Advantageously, the appended bit pattern is one of 01111, 0111, 011, and 01.

Advantageously, the bit pattern is one of 10000, 1000, 100, 10, 1.

Advantageously, the method further comprises appending a bit pattern to the NICAM signal that approximates a rounding of the NICAM signal.

According to a further aspect, one or more computer-readable media storing computer-executable instructions are provided which, when executed by a processor on a computer system, perform a method for, reducing the quantization bias error in a Near Instantaneous Companded Audio Multiplex (NICAM) signal, the method comprising:
receiving a scale factor that indicates a number of bits of a NICAM signal that have been truncated from the signal;
receiving the NICAM signal, the NICAM signal including the predetermined umber of truncated bits; and
appending a bit pattern to the NICAM signal, the bit pattern that replaces the predetermined number of zero bits, the bit pattern comprising at least one non-zero bit.

Advantageously, the method further comprises appending a bit pattern to the NICAM signal that approximates a rounding of the NICAM signal.

According to an aspect, a system comprises:
a Near Instantaneous Companded Audio Multiplex (NICAM) receiver that receives a NICAM signal, said NICAM signal that comprises a predetermined number of truncated bits, the receiver that appends a predetermined bit pattern to the NICAM signal, the predetermined bit pattern comprising at least one non-zero bit.

Advantageously, the predetermined number of truncated bits is one of 1 bit, 2 bits, 3 bits, and 4 bits.

Advantageously, the predetermined bit pattern is one of 0111, 011, and 01.

Advantageously, the predetermined bit pattern is one of 1000, 100, 10, and 1.

Advantageously, the predetermined number of truncated bits is one of I bit, 2 bits, 3 bits, and 4 bits.

Advantageously, the predetermined bit pattern is one of 01111, 0111, 011, and 01.

Advantageously, the predetermined bit pattern is one of 10000, 1000, 100, 10, and 1.

Advantageously, the receiver appends the predetermined pattern in the location in the NICAM signal that was previously occupied by the truncated bits.

Advantageously, the NICAM receiver comprises a decoder.

Advantageously, the predetermined bit pattern approximates a rounding of the NICAM signal.

According to an aspect, a method comprises:
receiving a Near Instantaneous Companded Audio Multiplex (NICAM) signal, the NICAM signal that comprises a plurality of bits, a predetermined number of the plurality of bits having been truncated at the signal transmitter;
receiving a scale factor that indicates the predetermined number of truncated bits;
selecting a bit pattern from a collection of bit patterns, the collection of bit patterns comprising at least non-zero bit;
   and
appending the selected bit pattern to the NICAM signal, the bit pattern that replaces the predetermined number of truncated bits.

### BRIEF DESCRIPTION OF THE DRAWINGS

The objects and advantages of the invention will be apparent upon consideration of the following detailed description, taken in conjunction with the accompanying drawings, in which like reference characters refer to like parts throughout, and in which:

FIG. 1 is a schematic diagram sample from a block in which the amplitude of the largest audio sample is up to one sixteenth of the maximum possible amplitude;

FIG. 2 is a schematic diagram sample from a block in which the amplitude of the largest audio sample is up to one eighth of the maximum possible amplitude;

FIG. 3 is a schematic diagram sample from a block in which the amplitude of the largest audio sample is up to one quarter of the maximum possible amplitude;

FIG. 4 is a schematic diagram from a block in which the amplitude of the largest audio sample is up to one half of the maximum possible amplitude;

FIG. 5 is a schematic diagram from a block in which the amplitude of the largest audio sample is the maximum possible amplitude;

FIG. 6 is a schematic diagram from a block in which the amplitude of the largest audio sample is the maximum possible amplitude and the bits are set according to embodiments of the invention;

FIG. 7 is a schematic diagram from a block in which the amplitude of the largest audio sample is the maximum possible amplitude and the bits are set according to other embodiments of the invention;

FIG. 8 is a schematic diagram from a block in which the amplitude of the largest audio sample is one half the maximum possible amplitude and the bits are set according to embodiments of the invention;

FIG. 9 is a schematic diagram from a block in which the amplitude of the largest audio sample is one half the maximum possible amplitude and the bits are set according to other embodiments of the invention; and

FIG. 10 is a schematic diagram of an illustrative single or multi-chip module of this invention in a data processing system.

### DETAILED DESCRIPTION OF THE INVENTION

In the following description of the various embodiments, reference is made to the accompanying drawings, which form a part hereof, and in which is shown by way of illustration various embodiments in which the invention may be practiced. It is to be understood that other embodiments may be utilized and structural and functional modifications may be made without departing from the scope and spirit of the present invention.

As will be appreciated by one of skill in the art upon reading the following disclosure, various aspects described herein may be embodied as a method, a data processing system, or a computer program product. Accordingly, those aspects may take the form of an entirely hardware embodiment, an entirely software embodiment or an embodiment combining software and hardware aspects. Furthermore, such aspects may take the form of a computer program product stored by one or more computer-readable storage media having computer-readable program code, or instructions, embodied in or on the storage media. Any suitable computer readable storage media may be utilized, including hard disks, CD-ROMs, optical storage devices, magnetic storage devices, and/or any combination thereof. In addition, various signals representing data or events as described herein may be transferred between a source and a destination in the form of electromagnetic waves traveling through signal-conducting media such as metal wires, optical fibers, and/or wireless transmission media (e.g., air and/or space).

Typically, the decoder for a NICAM encoded signal expands the compressed signal by replacing the removed most significant bits (msb's) and appending from 0 to 4 zeros in place of the truncated lsb's. The number of appended zeros is determined by the 3-bit scale factor code. However, this method typically retains the biased error introduced in the encoder. In addition, the resulting time varying error occupies a low frequency range, and is therefore amplified by the lowpass deemphasis filter in the decoder.

Methods according to the invention, however, may preferably reduce the effect of the error caused by the truncation of bits as implemented in the companding. The number of truncated bits for every sound sample is known at the decoder because the 3-bit scale factor information is transmitted along with the sound samples. Rather than simply appending the required number of zeros to the sound samples based on the scale factor information, the decoder can append a different bit pattern in order to reduce the quantization factor. The following two tables provide two bit patterns according to the invention that may be appended to reduce the quantization error. It should be noted that in each of the bit patterns in TABLE 1, the four (4) truncated bits have been replaced by five (5) bits in order to more completely eliminate the error caused by the truncation.

**TABLE 1**

| Scale Factor | Appended Bit Pattern (according to the invention) | Alternate Appended Bit Pattern (according to the invention) |
|---|---|---|
| 111 | 10000 | 01111 |
| 110 | 1000 | 0111 |
| 101 | 100 | 011 |
| 011 | 10 | 01 |
| Otherwise | 1 | 0 |

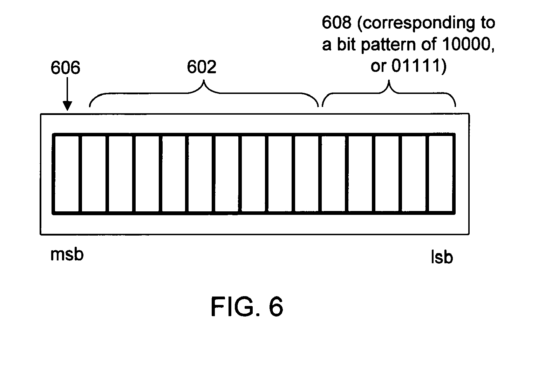

Such embodiments of the invention as shown in TABLE 1 produce 15-bit sound samples and may substantially reduce the quantization error bias. FIG. 6 shows that the four truncated bits have been replaced by five appended bits 608. Specifically, the five appended bits 608, which replace the four zeroed-out truncated bits (such as bits 508 in FIG. 5), may preferably be either 10000 or 01111 as shown in the row of TABLE 1 that corresponds to scale factor 111. In this embodiment of the invention, the bits truncated at the transmission end according to the 300 163 v1.2.1 NICAM standard, have been replaced with 10000 or 01111 at the receiving end. Bits 602 preferably correspond to the nine (9) bits of the transmitted audio signal described above while bit 606 preferably corresponds to the sign bit described above.

In the embodiment in which the truncated bits have been replaced with 01111, the quantization error bias has been reduced to near zero. It should be noted that in these embodiments that add an additional bit to the sound sample, additional, yet commonly known, hardware may be required at the receiver end to accommodate the processing of a 15-bit signal instead of a 14-bit signal.

The following TABLE 2 shows embodiments of the invention that produce 14-bit sound samples.

**TABLE 2**

| Scale Factor | Appended Bit Pattern (according to the invention) | Alternate Appended Bit Pattern (according to the invention) |
|---|---|---|
| 111 | 1000 | 0111 |
| 110 | 100 | 011 |
| 101 | 10 | 01 |
| 011 | 1 | 0 |
| Otherwise | (none) | (none) |

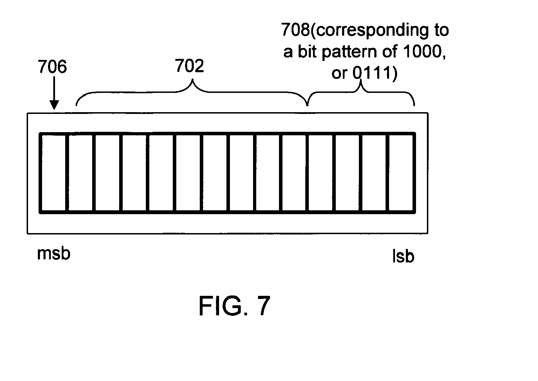

Such embodiments of the invention as shown in TABLE 2 produce 14-bit sound samples and may also substantially reduce the quantization error bias. FIG. 7 shows that the four truncated bits have been replaced by four appended bits 708. Bits 702 preferably include the signal. Bit 706 is preferably the sign bit. Specifically, the four appended bits 708, which replace the four truncated bits (such as bits 508 in FIG. 5), may preferably be either 1000 or 0111 as shown in the row of TABLE 2 that corresponds to scale factor 111. To reiterate, in these embodiments of the invention, the truncated bits, which were truncated at the transmission end of the signal according to the 300 163 v1.2.1 NICAM standard, have been replaced with 1000 or 0111 at the receiving end.

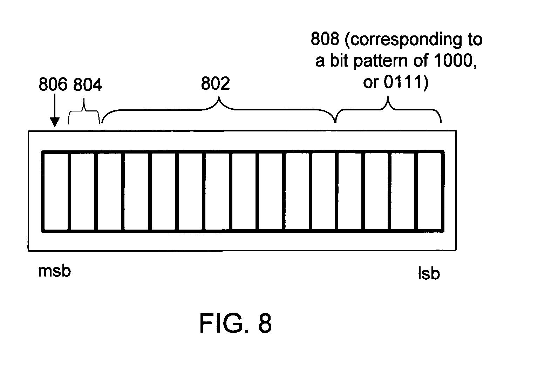

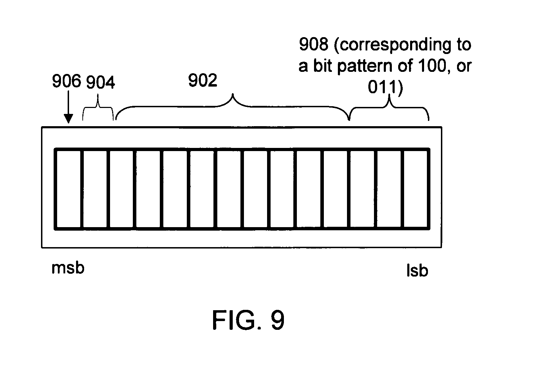

For example, FIGs. 8 and 9 correspond to the rows of TABLES 1 and 2 that are associated with the scale factor 110. FIG. 8 shows that the three truncated bits have been replaced by four appended bits 808. Specifically, the four appended bits 808, which replace the three truncated bits (such as bits 408 in FIG. 4), may preferably be either 1000 or 0111 as shown by the two entries in the row of TABLE 1 that corresponds to scale factor 110. In this embodiment of the invention, the bits truncated at the transmission end according to the 300 163 v1.2.1 NICAM standard, have been replaced with 1000 or 0111 at the receiving end. Bits 802 preferably correspond to the nine (9) bits of the transmitted audio signal described above, bit 806 preferably corresponds to the sign bit described above, and bit 804 corresponds to an additional bit of the audio signal (that, in this example, will be merely redundant of bit 806).

FIG. 9 shows that the three truncated bits have been replaced by three appended bits 908. Bits 902 preferably include the audio signal. Bit 906 is preferably the sign bit. Bit 904 is a redundant extension of bit 906. The three appended bits 908, which replace the three truncated bits (such as bits 508 in FIG. 5), may preferably be either 100 or 011 as shown in the row of TABLE 2 that corresponds to scale factor 110. To reiterate, in these embodiments of the invention, the bits truncated at the transmission end of the signal according to the 300 163 v1.2.1 NICAM standard, have been replaced with 100 or 011 at the receiving end.

It should be noted that the analysis set forth above with respect to FIGs. 6-9 that corresponds to the first and second rows of TABLES 1 and 2, respectively, can be extended to the other rows of TABLES 1 and 2 depending on the scale factor. Accordingly, the embodiments of the invention can cover a complete range of signal amplitudes and provide a comprehensive receiver-side solution to the problem created by the truncating in the aforementioned NICAM standard.

The foregoing methods can result in a significant improvement in the SNR of the decoded signal. Other appended bit patterns, which are within the scope of the invention, that are similar to those described above can also reduce the quantization error. The patterns described above may minimize the quantization error to the greatest extent. Other suboptimum patterns may also be possible. Suboptimum patterns may include bit patterns that vary according to the different scale factors yet do not produce minimum quantization error.

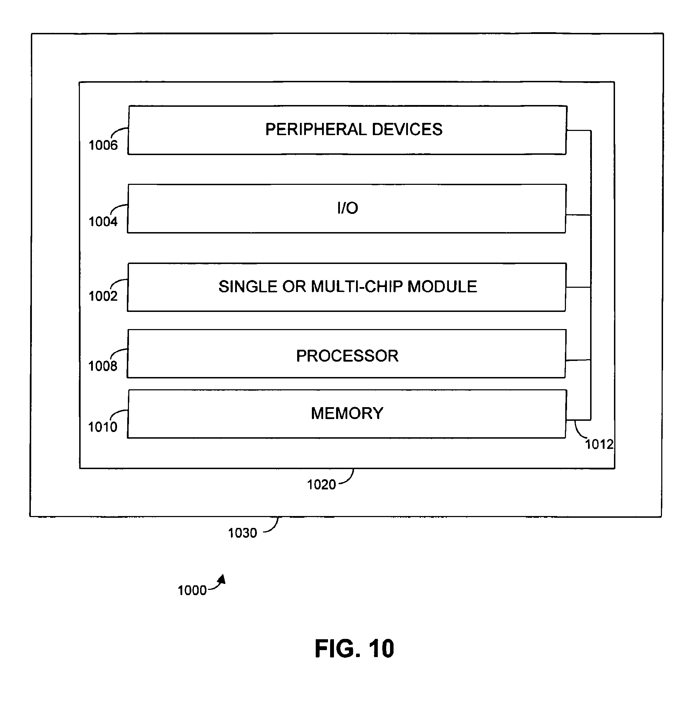

FIG. 10 shows a single or multi-chip module 1002 according to the invention, which can be one or more integrated circuits, in an illustrative data processing system 1000 according to the invention. Data processing system 1000 may include one or more of the following components: I/O circuitry 1004, peripheral devices 1006, a processor 1008 and memory 1010. These components are coupled together by a system bus or other interconnections 1012 and are populated on a circuit board 1020 which is contained in an end-user system 1030. System 1000 may be configured for use in a NICAM digital sound receiver according to the invention. It should be noted that system 1000 is only exemplary, and that the true scope and spirit of the invention should be indicated by the following claims.

The invention may be described in the general context of computer-executable instructions, such as program modules, being executed by a computer. More specifically, the invention may be described as a computer implemented as a NICAM digital sound decoder. Generally, program modules include routines, programs, objects, components, data structures, etc. that perform particular tasks or implement particular abstract data types.

Aspects of the invention have been described in terms of illustrative embodiments thereof. A person having ordinary skill in the art will appreciate that numerous additional embodiments, modifications, and variations may exist that remain within the scope and spirit of the appended claims. For example, one of ordinary skill in the art will appreciate that the steps illustrated in the figures may be performed in other than the recited order and that one or more steps illustrated may be optional. The methods and systems of the above-referenced embodiments may also include other additional elements, steps, computer-executable instructions, or computer-readable data structures. In this regard, other embodiments are disclosed herein as well that can be partially or wholly implemented on a computer-readable medium, for example, by storing computer-executable instructions or modules or by utilizing computer-readable data structures.

Thus, systems and methods for increasing audio SNR in a NICAM digital sound decoder have been described.

## Claims

1. A method comprising:
receiving a Near Instantaneous Companded Audio Multiplex (NICAM) signal, the NICAM signal that comprises a plurality of bits, a predetermined number of the plurality of bits having been truncated at the signal transmitter;
receiving a scale factor that indicates the predetermined number of truncated bits; and
appending a bit pattern to the NICAM signal, the bit pattern that replaces the predetermined number of truncated bits, the bit pattern comprising at least one non-zero bit.

2. The method of claim 1 wherein the predetermined number of truncated bits is one of 1 bit, 2 bits, 3 bits, and 4 bits.

3. The method of claim 1 wherein the bit pattern is one of 0111, 011, and 01.

4. The method of claim 1 wherein the bit pattern is one of 1000, 100, 10, 1.

5. The method of claim 1 wherein the predetermined number of truncated bits is one of I bit, 2 bits, 3 bits, and 4 bits.

6. The method of claim 1 wherein the appended bit pattern is one of 01111, 0111, 011, and 01.

7. One or more computer-readable media storing computer-executable instructions which, when executed by a processor on a computer system, perform a method for, reducing the quantization bias error in a Near Instantaneous Companded Audio Multiplex (NICAM) signal, the method comprising:
receiving a scale factor that indicates a number of bits of a NICAM signal that have been truncated from the signal;
receiving the NICAM signal, the NICAM signal including the predetermined umber of truncated bits; and
appending a bit pattern to the NICAM signal, the bit pattern that replaces the predetermined number of zero bits, the bit pattern comprising at least one non-zero bit.

8. A system comprising:
a Near Instantaneous Companded Audio Multiplex (NICAM) receiver that receives a NICAM signal, said NICAM signal that comprises a predetermined number of truncated bits, the receiver that appends a predetermined bit pattern to the NICAM signal, the predetermined bit pattern comprising at least one non-zero bit.

9. The system of claim 8 wherein the predetermined number of truncated bits is one of 1 bit, 2 bits, 3 bits, and 4 bits.

10. A method comprising:
receiving a Near Instantaneous Companded Audio Multiplex (NICAM) signal, the NICAM signal that comprises a plurality of bits, a predetermined number of the plurality of bits having been truncated at the signal transmitter;
receiving a scale factor that indicates the predetermined number of truncated bits; selecting a bit pattern from a collection of bit patterns, the collection of bit patterns comprising at least non-zero bit;
and
appending the selected bit pattern to the NICAM signal, the bit pattern that replaces the predetermined number of truncated bits.
